**Europäisches Patentamt**

**European Patent Office**

**Office européen des brevets**

(19)

(11) Veröffentlichungsnummer : **0 432 609 B1**

## (12) EUROPÄISCHE PATENTSCHRIFT

(45) Veröffentlichungstag der Patentschrift :
**08.11.95 Patentblatt 95/45**

(21) Anmeldenummer : **90123102.7**

(22) Anmeldetag : **03.12.90**

(51) Int. Cl.⁶ : $G03F\ 7/38$, $G03F\ 7/20$

(54) **Verfahren zur Herstellung negativer Kopien.**

(30) Priorität : **12.12.89 DE 3940911**

(43) Veröffentlichungstag der Anmeldung :
**19.06.91 Patentblatt 91/25**

(45) Bekanntmachung des Hinweises auf die
Patenterteilung :
**08.11.95 Patentblatt 95/45**

(84) Benannte Vertragsstaaten :
**DE GB**

(56) Entgegenhaltungen :
**EP-A- 0 178 594**
**WO-A-88/07705**
**PATENT ABSTRACTS OF JAPAN, vol. 11, no.**
**299 (P-621)(2746) 29. September 1987 &**
**JP-A-62 091 938**

(73) Patentinhaber : **HOECHST**
**AKTIENGESELLSCHAFT**
**D-65926 Frankfurt am Main (DE)**

(72) Erfinder : **Gaschler, Otfried, Dipl.-Ing.**
**Lilienthalstrasse 19**
**W-6200 Wiesbaden (DE)**
Erfinder : **Elsässer, Andreas, Dr. Dipl.-Chem.**
**Hertastrasse 1B**
**W-6270 Idstein (DE)**
Erfinder : **Mohr, Dieter, Dr. Dipl.-Chem.**
**Eaubonner Strasse 8**
**W-6501 Budenheim (DE)**
Erfinder : **Frass, Werner, Dr. Dipl.-Chem.**
**Erbsenacker 37**
**W-6200 Wiesbaden-Naurod (DE)**

EP 0 432 609 B1

**Beschreibung**

Die Erfindung betrifft ein verfahren zur Herstellung negativer Kopien, bei dem ein licht- bzw. strahlungsempfindliches Aufzeichnungsmaterial aus einem Schichtträger und einer darauf aufgebrachten normalerweise positiv arbeitenden licht- bzw. strahlungsempfindlichen Schicht, die als wesentliche Bestandteile ein 1,2-Chinondiazid und/oder ein Gemisch aus einer unter Einwirkung von aktinischer Strahlung starke Säure bildenden Verbindung und einer Verbindung mit mindestens einer durch Säure spaltbaren C-O-C- Gruppierung enthält, bildmäßig bestrahlt, thermisch behandelt, nach Abkühlen vollflächig bestrahlt und dann mit einem alkalischen Entwickler entwickelt wird.

Positiv arbeitende lichtempfindliche Gemische, deren bildmäßig belichtete Bereiche löslich werden und in denen die unbelichteten Bereiche unlöslich sind, sind bekannt. Für die Herstellung derartiger Materialien werden in der Praxis vor allem Schichten mit o-Chinondiaziden als lichtempfindliche Verbindungen verwendet, die noch Harze mit alkalilöslich machenden Gruppen enthalten, z.B. Phenolharze.

Lichtempfindliche Gemische auf Basis säurespaltbarer Verbindungen sind ebenfalls bekannt. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine. Als Bindemittel werden auch Harze mit alkalilöslich machenden Gruppen verwendet.

Es ist auch bekannt, daß man ein normalerweise positiv arbeitendes Kopiermaterial auf Basis von o-Chinondiaziden in Gegenwart geeigneter Zusatzstoffe durch eine bestimmte Folge von Behandlungen als negativ arbeitendes Kopiermaterial einsetzen kann. In der GB-A 2 082 339 ist ein derartiges Umkehrverfahren beschrieben, bei dem ein lichtempfindliches Gemisch, bestehend aus einem o-Chinondiazid und mindestens einem Resol, als negativ arbeitendes Aufzeichnungsmaterial benutzt wird. In der DE-A 25 29 054, entsprechend US-A 4 104 070, werden Resistschichten auf Basis von 1,2-Chinondiaziden für ein Umkehrverfahren beschrieben, die als Zusatzstoff Hydroxyethylimidazoline enthalten. Ein ähnliches Material mit einem Gehalt an sekundären oder tertiären Aminen wird in der US-A 4 196 003 beschrieben. In EP-A 0 133 216, entsprechend US-A 4 581 321 wird ein Umkehrverfahren beschrieben, welches als Zusatz zur o-Chinondiazid-haltigen Kopierschicht einen Hexamethylolmelaminether enthält, der vorzugsweise als Vernetzungsmittel bei Polymerreaktionen Verwendung findet, während in EP-A 0 131 238, entsprechend US-A 4 576 901, ein Umkehrverfahren beschrieben wird, dessen lichtempfindliches Material keinen der oben erwähnten basischen oder sauren Zusätze erfordert. Aus DE-A 37 11 263 bzw. 37 25 949 sind verschiedene s-Triazin-Derivate als die thermische Härtung fördernde Substanzen bei Umkehrverfahren mit normalerweise positiv arbeitenden Rezepturen bekannt.

Bekannt ist ferner ein Positiv-Negativ-Umkehrverfahren auf Basis säurespaltbarer Verbindungen anstelle von 1,2-Chinondiaziden, wie es in EP-A 0 082 463, entsprechend US-A 4 506 006 beschrieben ist.

Die bekannten Umkehrverfahren enthalten im Prinzip die gleiche Folge von Verarbeitungsschritten, wobei man nach der bildmäßigen Belichtung die Druckplatte erwärmt, nach dem Abkühlen nochmals ohne Vorlage nachbelichtet und dann mittels eines wäßrig-alkalischen Entwicklers entwickelt.

Die bekannten Umkehrverfahren beruhen darauf, daß die entstandenen Lichtzersetzungsprodukte beim Erwärmen ein unlösliches Reaktionsprodukt ergeben. Diese thermische Folgereaktion erfolgt vorzugsweise in Gegenwart bestimmter basischer oder saurer Zusätze zur Kopierschicht oder in Gegenwart bestimmter Vernetzungsmittel mit multifunktionalen reaktionsfähigen Gruppen.

Für die Praxis ist von großer Bedeutung, daß die einzelnen Verarbeitungsschritte sicher gehandhabt werden können und zum Beispiel bildmäßiges Bestrahlen, Erwärmen zur Bildumkehr, Abkühlen, Nachbelichten und Entwickeln den üblichen Verfahrensschritten entsprechen. Ein ausreichender Bildumkehrspielraum sollte dabei gewährleistet sein.

Unter Bildumkehrspielraum ist die Breite des Temperaturbereichs zu verstehen innerhalb dessen die Konversion durchgeführt werden kann, bzw. die Toleranzbreite der für die Konversion erforderlichen Zeit.

Die für Gemische auf Basis von 1,2-Chinondiaziden beschriebenen Zusätze lassen sich einteilen in Additive, die in Gegenwart der bei der Bestrahlung gebildeten Säure thermisch eine Vernetzungsreaktion im lichtempfindlichen Gemisch bewirken und in basische Zusätze, die mit der bei der Bestrahlung gebildeten Säure zu einem Salz reagieren und dadurch die zur Decarboxylierung der Säure erforderliche Energie herabsetzen (C.G. Willson: "Image reversal. The Production of a Negative Image in a Positive Photoresist", Interface 82, San Diego 1982).

Eine spezielle Ausführungsform besteht darin, daß der Zusatz zur Verbreiterung des Bildumkehrspielraums nicht von vornherein in der strahlungsempfindlichen Schicht zugegen ist, sondern zwischen bildmäßiger Belichtung und thermischer Behandlung angetragen wird, wie dies etwa in DE-A 35 41 451 und US-A 4 775 609 beschrieben ist, indem das Material z.B. einer Ammoniak-Atmosphäre ausgesetzt wird.

2

Wie bekannt wird das Kopiermaterial zur Umkehrbehandlung nach dem bildmäßigen Bestrahlen bzw. Belichten unter einer Vorlage ohne weitere Zwischenbehandlung erwärmt. Das Erwärmen kann durch Bestrahlung, Konvektion, durch Kontakt mit erwärmten Flächen, zum Beispiel Walzen, oder Tauchen in ein erwärmtes Bad einer inerten Flüssigkeit, zum Beispiel Wasser, erfolgen. Die Erwärmungstemperatur liegt zwischen 80 und 150, insbesondere zwischen 100 bis 130 °C. Zwar werden derartige Temperaturen im allgemeinen von den Gemischen vertragen, es hat sich jedoch gezeigt, daß durch die thermische Behandlung ein grundsätzlicher Nachteil dieser Umkehrverarbeitung hervorgerufen wird, indem das Entwicklungsverhalten der strahlungsempfindlichen Schicht ungünstig beeinflußt wird. So ergeben sich in der Regel deutlich erhöhte Entwicklungszeiten. Bei maschineller Verarbeitung mit bestimmten Taktzeiten hat dies zur Folge, daß die Verarbeitungsgeschwindigkeiten und damit der Plattendurchsatz deutlich zurückgenommen werden muß, in manchen Fällen sogar auch, daß selbst bei den niedrigsten Verarbeitungsgeschwindigkeiten eine sichere Entwicklung nicht mehr möglich ist.

Um diesem ungünstigen Einfluß der thermischen Behandlung im Ofen zu begegnen, wurde bereits vorgeschlagen, die ganzflächige Ausbelichtung unter Wasser vorzunehmen (GB-A 2 188 448). Diese Maßnahme ist geeignet, die bei der Entwicklung auftretenden Probleme zu eliminieren. Da jedoch die gerätetechnische Realisierung nicht unproblematisch ist, handelt es sich jedoch noch nicht um eine optimale Lösung.

Es war Aufgabe der vorliegenden Erfindung ein Verfahren anzugeben, das die Umkehrverarbeitung ermöglicht ohne daß die beschriebenen Entwicklungsprobleme auftreten und das apparativ einfacher zu realisieren ist als dies bisher möglich war.

Die Lösung dieser Aufgabe geht aus von einem Verfahren zur Herstellung negativer Kopien der eingangs genannten Art und sie ist dadurch gekennzeichnet, daß man die thermische Behandlung mit Wasser oder mit einer wäßrigen Lösung bei Temperaturen im Bereich von 50 bis 100 °C innerhalb von etwa einer Sekunde und 5 Minuten, die vollflächige Bestrahlung an dem noch warmen Aufzeichnungsmaterial und die anschließende Entwicklung innerhalb von etwa 10 Sekunden und 2 Minuten durchführt. Vorzugsweise nimmt man die thermische Behandlung in einem Temperaturbereich von etwa 60 - 90 °C innerhalb von 5 Sekunden und 1 Minute und die Entwicklung innerhalb von etwa 15 Sekunden und 1 Minute vor. Die vollflächige Bestrahlung erfolgt vorzugsweise im Bereich von etwa 50 - 90 °C.

Das erfindungsgemäße Verfahren kann beispielsweise so durchgeführt werden, daß das belichtete Aufzeichnungsmaterial in einer Küvette der heißen wäßrigen Lösung ausgesetzt wird, ein Stau- oder ein heißes Tauchbad durchläuft, über Düsen besprüht wird oder etwa in einer Kammer dem Aerosol der heißen wäßrigen Lösung ausgesetzt wird. Auch sind Kombinationen dieser Antragsweisen denkbar.

Die optimale Einwirkzeit und Temperatur der wäßrigen Lösung sind im Einzelfall zu ermitteln, da sie ganz wesentlich von der Zusammensetzung der strahlungssempfindlichen Schicht abhängen. Daneben spielen auch die Zusammensetzung der wäßrigen Lösung und die Art des Schichtträgers der strahlungsempfindlichen Schicht eine Rolle. Allgemein ist festzustellen, daß überraschenderweise diese Art der Konvertierung mit deutlich niedrigeren Temperaturen und kürzeren Einwirkzeiten möglich ist, als das herkömmliche Verfahren mit Heißluft in einem Heißluftofen.

Unter einer erfindungsgemäß zu verwendenden wäßrigen Lösung ist eine Lösung zu verstehen, die mindestens 10 Gewichtsprozent Wasser enthält. Daneben kann eine solche Lösung vorteilhaft eine Reihe von Zusatzstoffen enthalten:

Die Lösung kann mindestens eine oberflächenaktive Substanz enthalten. Sie dient zur Einstellung ihrer Oberflächenspannung. Insbesondere bei Sprühantrag sind Oberflächenspannungen von $\leqq$ 50 mN/m anzustreben, um eine rasche Benetzung der Kopierschicht zu gewährleisten. Als Tenside sind grundsätzlich sowohl kationische, anionische als auch nichtionische oder Tensidkombinationen sowie Tenside vom Betaintyp einsetzbar. Bei Tensiden mit basischen Einheiten wie Polyethereinheiten, Amid-, Amin- oder quaternären Ammonium-Einheiten wird häufig das Konversionsverhalten positiv beeinflußt. Bei der Auswahl der Tenside bzw. Lösungsmittel - dies gilt für alle Zusatzstoffe zur wäßrigen Lösung - ist darauf zu achten, daß durch sie kein wesentlicher Abtrag der Kopierschicht während des Konversionsprozesses erfolgt, was man in Vorversuchen rasch ermitteln kann.

Die erfindungsgemäß verwendete wäßrige Lösung kann weiterhin vorteilhaft basische oder saure Substanzen zur Einstellung des pH-Wertes enthalten. Der optimale pH-Wert der für die Konvertierung eingesetzten wäßrigen Lösung hängt von der Zusammensetzung der Kopierschicht ab. Bei Kopierschichten auf Basis von 1,2-Chinondiaziden, die keine weiteren die Umkehrverarbeitung begünstigende Zusätze enthalten, ist die Zugabe basischer Substanzen vorteilhaft. Die Substanzen können sowohl anorganischer als auch organischer Natur sein. Der mögliche pH-Bereich liegt zwischen 1 und 13. Bei stärker saurem Medium kommt es häufig zu einem Angriff gegen die Schichtträger bzw. erfolgt ein Angriff gegen die Kopierschicht vermutlich durch Protonierung basischer Bestandteile der Kopierschicht. Bei stärker alkalischem Milieu tritt ein erhöhter Angriff gegen die Kopierschicht durch die Überführung des in der Regel eingesetzten Phenolharz-Bindemittels in die

EP 0 432 609 B1

anionische Form auf. Vorteilhaft arbeitet man in einem pH-Bereich von 5 - 8.

Der wäßrigen Lösung können vorteilhaft Puffersubstanzen zur Stabilisierung des pH-Wertes zugesetzt sein. Durch diese Maßnahme wird zum einen eine höhere Ergiebigkeit der zur Konvertierung eingesetzten Lösung erreicht, da aus der Kopierschicht herausgelöste Bestandteile den pH-Wert verschieben können; zum anderen sind die erhaltenen Ergebnisse konstanter. Als Puffer sind die gängigen Systeme einsetzbar. Vorzugsweise ist die wäßrige Losung im pH-Bereich von 5 bis 8 gepuffert.

Die wäßrige Lösung kann vorteilhaft weiterhin Komplexbildner enthalten. Hierdurch werden Niederschlagsbildungen verhindert, wenn mit nicht entsalztem Wasser gearbeitet wird. Dies ist vor allem deswegen von Bedeutung, da die verschiedensten Anwender mit verschiedensten Wässern arbeiten.

Der wäßrigen Lösung können auch Substanzen zugesetzt sein, die die Viskosität der Lösung beeinflussen, z.B. erhöhen, soweit dies durch das gewählte Antragsverfahren der Konvertierungslösung notwendig sein sollte. Zur Anhebung der Viskosität werden insbesondere wasserlösliche Polymere herangezogen.

Schließlich kann die erfindungsgemäß verwendete wäßrige Lösung vorteilhaft Substanzen enthalten, die die Wärmeleitfähigkeit der Lösung erhöhen. Durch rasche Wärmeübertragung auf das Aufzeichnungsmaterial lassen sich kurze Zeiten für die Konvertierung erreichen. Auf einfache Weise geschieht dies durch Anhebung des Salzgehalts der Lösung.

Ferner kann die wäßrige Lösung noch Antischaummittel, soweit erforderlich, und Substanzen, die den Dampfdruck der wäßrigen Lösung reduzieren, enthalten.

Durch die Erfindung wird erreicht, daß durch die thermische Behandlung im niedrigen Temperaturbereich von 50 bis 100 °C, vorzugsweise 60 - 90 °C, bei der Ausbelichtung der noch warmen Platte keine Funktionsbeeinträchtigung festzustellen ist, so daß die Entwicklung mit einem wäßrig-alkalischen Entwickler innerhalb von etwa 10 Sekunden und 2 Minuten, vorzugsweise von etwa 5 Sekunden und 1 Minute erfolgen kann, was im üblichen Rahmen der Praxis liegt und keinerlei spezielle Maßnahmen gegenüber der Verarbeitung einer normalerweise positiv arbeitenden Druckplatte erforderlich macht.

Ein solches Ergebnis war nicht zu erwarten, da nicht angenommen werden konnte, daß a) unter relativ milden Bedingungen die Konversion gelingen und b) die bei der Entwicklung der noch warm ausbelichteten Platte bestehenden Probleme beseitigt werden konnten.

Das verwendete licht- bzw. strahlungsempfindliche Aufzeichnungsmaterial sowie die erforderlichen Verfahrensschritte zu seiner Verarbeitung werden wie folgt beschrieben:

Als 1,2-Chinondiazide werden bevorzugt 1,2-Naphthochinondiazid-(2)-4-oder -5-sulfonsäure- oder Carbonsäureester oder -amide verwendet. Geeignete Verbindungen dieser Art sind bekannt und zum Beispiel in DE-C 938 233, entsprechend GB-A 739 654 beschrieben.

Die Menge von 1,2-Chinondiazidverbindungen beträgt im allgemeinen 3 bis 50, bevorzugt 7 bis 35 Gewichtsprozent, bezogen auf Gesamtfeststoff des licht- bzw. strahlungsempfindlichen Gemisches.

Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal-und/oder Ketalgruppierungen in der Hauptkette und

c) Verbindungen mit mindestens einer Enolether- oder N-Acyliminocarbonatgruppierung.

Durch Säure spaltbare Verbindungen des Typs a) als Komponenten strahlungsempfindlicher Gemische sind in der EP-A 0 022 571, entsprechend US-A 4 311 782, beschrieben; Gemische, die Verbindungen des Typs b) enthalten, sind in der DE-C 23 06 248, entsprechend US-A 3 779 778 beschrieben; Verbindungen des Typs c) sind aus EP-A 0 006 627, entsprechend US-A 4 248 957 bekannt.

Als lichtempfindliche Komponenten, die beim Belichten starke Säuren bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium- und Jodoniumverbindungen werden in der Regel eingesetzt in Form ihrer in organischen Lösemitteln löslichen Salze, meist als Abscheidungsprodukt, Hexafluorphosphor-, Hexafluorantimon- und arsensäure.

Grundsätzlich sind als halogenhaltige lichtempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar. Von diesen Verbindungen werden die s-Triazinderivate mit Halogenmethylgruppen, insbesondere Trichlormethylgruppen, und mit einem aromatischen bzw. ungesättigten Substituenten im Triazinkern, wie sie in DE-C 27 18 259, entsprechend US-A 4 189 323, beschrieben sind, bevorzugt. Ebenso geeignet sind 2-Trihalogenmethyl-5-vinyl-1,3,4-oxdiazole (DE-A 28 51 471, entsprechend US-A 4 212 970). Die Wirkung dieser

4

halogenhaltigen Verbindungen kann auch durch bekannte Sensibilisatoren spektral beeinflußt und gesteigert werden.

Beispiele für geeignete photochemische Säurespender sind:

4-Methyl-6-trichlormethyl-2-pyron,4-(3,4,5-Trimethoxy-styryl)-6-trichlormethyl-2-pyron, 4-(4-methoxy-styryl)-6-(3,3,3-trichlorpropenyl)-2-pyron, 2-Trichlormethyl-benzimidazol, 2-Tribrommethylchinolin, 2,4-Dimethyl-1-tribromacetyl-benzoesäure, 1,4-Bis-dibrommethyl-benzol, Tris-dibrommethyl-s-triazin, 2-(6-Methyoxy-naphth-2-yl)-, 2-(Naphth-1-yl)-, 2-(4-Ethoxyethylnaphth-1-yl)-, 2-(Benzo-pyran-3-yl)-, 2-(4-Methoxyanthrac-1-yl)-, 2-(4-Styrylphenyl)-, 2-(Phenanthr-9-yl)-4,6-bis-trichlor-methyl-s-triazin und die in den Beispielen aufgeführten Verbindungen.

Die Menge des photochemischen Säurespenders kann, je nach seiner chemischen Natur und der Zusammensetzung der Schicht, ebenfalls sehr verschieden sein. Günstige Ergebnisse werden erhalten mit etwa 0,5 bis zu 20 Gewichtsprozent, vorzugsweise 1 bis 12 Gewichtsprozent, bezogen auf den Gesamtfeststoff des Gemisches. Besonders für lichtempfindliche Schichten von Dicken über 0,01 mm empfiehlt es sich, relativ wenig Säurespender zu verwenden.

Als Bindemittel werden Polykondensate oder Polymerisate mit freien phenolischen Hydroxylgruppen eingesetzt, wobei der Gehalt an phenolischen Hydroxylgruppen bevorzugt zwischen 2 und 9 mmol/g Bindemittel liegt. Als Beispiele für Polykondensate sind zu nennen, Phenolharze vom Novolaktyp oder hydroxysubstituierte Aramide. Als Beispiele für Polymerisate seien genannt: Homo- und Copolymerisate von Vinylphenolen (DE-C 23 22 230, entsprechend US-A 3 869 292), Polymerisate der Ester von Acrylsäuren mit Phenolen (EP-A 0 212 439) oder Copolymerisate von Hydroxyphenylmaleinimiden (EP-A 0 187 517). Die Menge des Bindemittels beträgt im allgemeinen 20 bis 90, vorzugsweise 50 bis 85 Gewichtsprozent der nichtflüchtigen Bestandteile des Gemisches.

Zusätzlich können noch zahlreiche andere Oligomere und Polymere mitverwendet werden, z.B. Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgmeinen nicht mehr als 20 Gewichtsprozent vom Bindemittel mit seitenständigen phenolischen Gruppen. In geringen Mengen kann die lichtempfindliche Schicht für spezielle Erfordernisse wie Flexibilität, Haftung, Glanz etc. außerdem noch Substanzen wie Polyglykole, Celluloseether, z.B. Ethylcellulose, Netzmittel und feinteilige Pigmente enthalten.

Ferner können dem lichtempfindlichen Gemisch noch lösliche oder auch feinteilige dispergierbare Farbstoffe sowie, je nach Anwendungszweck, auch UV-Absorber zugesetzt werden. Gemische auf Basis von 1,2-Chinondiaziden, welche einen breiten Spielraum bei der Positiv-Negativ-Konversion besitzen sollen, enthalten weiterhin einen oder mehrere der oben im Detail beschriebenen Zusätze zur Erweiterung des Bildumkehrspielraums.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe, wie Trichlorethylen und 1,1,1-Trichlorethan, Alkohole, wie n-Propanol, Ether, wie Tetrahydrofuran, Alkoholether, wie Ethylenglykol-monoethylether und Ester, wie Butylacetat. Es können auch Gemische verwendet werden, die zudem noch für spezielle Zwecke Lösungsmittel, wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether allein oder im Gemisch werden besonders bevorzugt.

Als Schichtträger für Schichtdicken unter ca. 10 μm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z.B. mit Polyvinylphosphonsäure, Silikaten, Phosphaten, Hexafluorzirkonaten oder mit hydrolysiertem Tetraethylorthosilikat vorbehandelt sein kann.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle, z.B. einen Argon- oder Krypton-Ionen-Laser enthalten. Die Bestrahlung kann ferner mit Elektronenstrahlen erfolgen. Auch Röntgenstrahlen können zur Bilderzeugung verwendet werden.

Die bildmäßig belichtete oder bestrahlte bzw. die vollflächig bestrahlte Schicht kann in bekannter Weise mit praktisch den gleichen Entwicklern, wie sie für handelsübliche Naphthochinondiazid-Schichten und Kopierlacke bekannt sind, entfernt werden, oder die erfindungsgemäßen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z.B. Alkaliphosphate, -silikate oder -hydroxide und ferner Netzmittel sowie gegebenenfalls kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurzzeitig auf erhöhte Temperaturen erwärmt werden, wie es für Diazoschichten aus der GB-PS 1 154 749 bekannt ist.

## Beispiele

Im folgenden werden Beispiele der bevorzugten Ausführungsformen angegeben. In den Beispielen stehen Gewichtsteile (Gt) und Volumenteile (Vt) im Verhältnis von g zu ccm. Prozent-und Mengenverhältnisse sind, wenn nichts anderes angegeben ist, in Gewichtseinheiten zu verstehen.

## Beispiel 1

Es wird eine Beschichtungslösung hergestellt aus

| | |
|---|---|
| 8,0 Gt | eines m-Kresol-Formaldehyd-Novolaks mit einem Gewichtsmittelwert von 6.000, |
| 1,6 Gt | eines Veresterungsproduktes aus 1 Mol 1,2-Naphthochinon-2-diazid-4-sulfonylchlorid und 1 Mol p-Cumylphenol, |
| 0,4 Gt | 2,4-Diethoxy-6-diethylamino-s-triazin, entsprechend DE-A-37 11 263, als Base, |
| 0,1 Gt | Kristallviolett (C.I. 42555), |
| 0,02 Gt | Sudangelb GGN (C.I. 11021), |
| 100 Gt | eines Lösungsmittelgemisches aus Tetrahydrofuran und Propylenglykolmonomethylether (55:45). |

Diese Lösung wird auf eine in Salzsäure aufgerauhte, in Schwefelsäure anodisierte und mit Polyvinylphosphonsäure hydrophilierte Aluminiumfolie schleuderbeschichtet.

Nach 2 Minuten Trocknen bei 100 °C resultiert eine Schichtdicke von 2 µm.

Die Druckplatten werden unter einer 5-kW-Metallhalogenidlampe im Abstand von 110 cm durch einen Halbtonstufenkeil mit 13 Dichtestufen von je 0,15 (Belichtungskeil "BK 01" der Hoechst AG) 65 Sekunden lang belichtet, 1 Minute bei verschiedenen Temperaturen in einem mit VE-Wasser (vollentsalztes Wasser) gefüllten Tauchbad bzw. in einem Umluftofen konvertiert und ohne Abkühlzeit 45 Sekunden lang ohne Vorlage ausbelichtet und dann in folgendem Entwickler 1 Minute (dies entspricht der Regelentwicklung) entwickelt:

8,5 Gt $Na_2SiO_3$ x 9 $H_2O$,

0,8 Gt NaOH und

1,5 Gt $Na_2B_4O_7$ x 10 $H_2O$ in

89,2 Gt $H_2O$.

In den Tabellen 1 a und 1 b sind in Abhängigkeit von der Konversionstemperatur die gefundenen Halbtonkeilwiedergaben der voll gedeckten Stufen bis zu der, die erstmals einen Schleier zeigt, angegeben.

Desweiteren sind in Tabellen 1 a und 1 b die Ergebnisse einer jeweiligen Kurzzeitentwicklung (15 Sekunden) aufgeführt, wobei durch Anfärben mit schwarzer Offsetfarbe geprüft wurde, ob die Kopierschicht an den Nichtbildstellen vollständig entfernt ist (tonfrei) oder noch teilweise vorhanden ist und Druckfarbe annimmt (tont).

<u>Tabelle 1 a</u>
Konversion im Umluft-Ofen

| Temperatur [°C] | Wiedergabe bei Regelentwicklung (1 Minute) | Aufent-wicklung (15 Sekunden) |
|---|---|---|
| 80 | - | tont |
| 90 | - 3 | tont |
| 100 | 1 - 3 | tont |
| 110 | 1 - 3 | tont |
| 120 | 1 - 4 | tont |
| 130 | 1 - 4 | tont |
| 140 | 1 - 4 | tont |
| 150 | 1 - 5 | tont |

<u>Tabelle 1 b</u>
Konversion im Wasserbad

| Temperatur [°C] | Wiedergabe bei Regelentwicklung (1 Minute) | Aufent-wicklung (15 Sekunden) |
|---|---|---|
| 50 | - | tonfrei |
| 60 | - 3 | tonfrei |
| 70 | 1 - 4 | tonfrei |
| 80 | 1 - 4 | tonfrei |
| 90 | 1 - 5 | tonfrei |
| 100 | 1 - 6 | tonfrei |

Die Ergebnisse zeigen, daß bei Konvertierung im Wasserbad bereits bei deutlich tieferer Temperatur eine der Konvertierung im Umluftofen vergleichbare Wiedergabe resultiert, das Aufentwicklungsverhalten ohne sonst übliche Abkühlung aber im gesamten geeigneten Temperaturbereich erheblich besser ist.

Ergänzend zu den Aufentwicklungsversuchen wurde folgende Testreihe durchgeführt:

Nach Konvertierung bei 75 °C im Wasserbad bzw. 125 °C im Umluftofen und ansonsten gleicher Verfahrensweise wurde durch Küvettenentwicklung in 5 Sekunden-Intervallen die Mindestentwicklungszeit bestimmt, d.h. die Zeit, bei der in den Nichtbildstellen zum ersten Mal kein Ton auftritt. Die Resultate sind in Tabelle 2 zusammengefaßt:

## Tabelle 2

| Konversions-medium | Konversions-temperatur | Mindestent-wicklungszeit |
|---|---|---|
| Heißluft | 125 °C | 35 Sekunden |
| Wasser | 75 °C | 10 Sekunden |

Weiterhin wurde der Einfluß des Konvertierungsverfahrens auf eine mögliche nachfolgende Positivverarbeitung untersucht, was im Photocomposing von Wichtigkeit ist. Hierzu wird die Regelbelichtungszeit der Positivverarbeitung entsprechend Kopiertabelle 2+ der FOGRA ohne Vorbehandlung bzw. nach einminütiger Heißluft- oder Heißwasser-Exposition bestimmt, sowie die Resistenz der unbelichteten Kopierschicht gegen die eingesetzte Entwicklerlösung (Tabelle 3).

## Tabelle 3:

| Medium | Temperatur [°C] | Regelbelich-tungszeit [Sekunden] | Entwickler-resistenz [Minuten] |
|---|---|---|---|
| | – | 65 | > 4 |
| Heißluft | 125 | 55 | > 4 |
| Wasser | 60 | 55 | > 4 |
| Wasser | 70 | 55 | > 4 |
| Wasser | 80 | 55 | > 4 |
| Wasser | 90 | 55 | > 4 |

Die Ergebnisse zeigen, daß das Photocomposing auch bei diesem Konvertierungsverfahren möglich ist.

Zur Ermittlung der Mindestkonversionszeit wurde folgender Versuch durchgeführt: Die Druckplatten wurden 65 Sekunden belichtet, anschließend verschiedene Zeiten bei 80 °C im Wasserbad bzw. 135 °C im Umluftofen getempert, ohne Abkühlung 45 Sekunden lang ohne Vorlage belichtet und 1 Minute entwickelt.

Die folgende Tabelle 4 zeigt die erhaltenen Halbtonkeilwiedergaben.

## Tabelle 4:

| Konvertierungs-zeit [Sekunden] | Halbtonkeilwiedergabe | |
|---|---|---|
| | Wasserbad | Umluftofen |
| 15 | − 4 | − |
| 20 | − 4 | − |
| 30 | 1 − 4 | − 3 |
| 40 | 1 − 5 | − 3 |
| 50 | 1 − 5 | 1 − 3 |
| 60 | 1 − 5 | 1 − 3 |

Die Ergebnisse zeigen, daß auch bezüglich der Konvertierungszeit die Temperung im Wasserbad Vorteile besitzt.

**Beispiel 2**

Die Umkehrverarbeitung entsprechend Beispiel 1 wurde wiederholt, wobei anstelle von VE-Wasser verschiedene wäßrige Tensid-Lösungen aufgesprüht und gestaut wurden. Als Temperatur wurde einheitlich 75 °C gewählt, die Konvertierungszeit der Lösungen war 1 Minute. Die Ergebnisse zeigt Tabelle 5.

## Tabelle 5

| Zusatz [Menge] | Charakte-risierung | Wiedergabe-bei Regel-entwicklung (1 Minute) | Aufent-wicklung (15 Sek) |
|---|---|---|---|
| | Vergleich | 1 − 4 | tonfrei |
| FT 448 [0,05 %] | anionisch | 1 − 4 | tonfrei |
| FT 719 [0,05 %] | nichtionisch | 1 − 4 | tonfrei |
| FT 738 [0,05 %] | kationisch | 1 − 4 | tonfrei |

Bei den eingesetzten Tensiden handelt es sich um Fluortenside der Bayer AG.
Die tensidhaltigen Lösungen zeigten ein deutlich unproblematischeres Benetzungsverhalten gegenüber der Kopierschicht.
Nachteilige Einflüsse auf die Umkehrverarbeitung waren nicht festzustellen.

**Beispiel 3**

Die Umkehrverarbeitung entsprechend Beispiel 1 wurde wiederholt, wobei anstelle von VE-Wasser Lösungen verwendet wurden, welche durch Schwefelsäure bzw. Natriumsilikat-Zugabe auf verschiedene pH-Werte eingestellt waren. Die Konvertierung erfolgte im Tauchbad, Zeit: 1 Minute, Temperatur: 75 °C; (Tabelle 6).

## Tabelle 6

| pH-Wert | Wiedergabe bei Regelentwicklung (1 Min) | Aufent-wicklung (15 Sek) | Positivregelbelichtungszeit nach Konvertierung |
|---------|------------------------------------------|--------------------------|------------------------------------------------|
| 2,3 | 1 - 4 | tonfrei | 55 |
| 3,5 | 1 - 4 | tonfrei | 55 |
| 5,0 | 1 - 4 | tonfrei | 55 |
| 7,2 | 1 - 4 | tonfrei | 55 |
| 9,0 | 1 - 4 | tonfrei | 50 |

Die Ergebnisse zeigen, daß das Umkehrverhalten über einen weiten pH-Wert-Bereich hin konstant ist.

**Beispiel 4**

Die Umkehrverarbeitung entsprechend Beispiel 1 wurde mit gepufferten bzw. ungepufferten wäßrigen Lösungen durchgeführt und geprüft, ob mit steigender Belastung (Endwert: 1 m² konvertierte Schicht pro Liter wäßrige Lösung) eine Veränderung in der Umkehrverarbeitung festzustellen ist (Tabelle 7).
Temperatur : 75 °C, Zeit : 1 Minute.

Tabelle 7

| Puffersystem | pH-Wert zu Be-ginn | pH-Wert bei Test-abbruch | Wieder-gabe bei Beginn bei Regelentwick-lung | Wieder-gabe bei Testab-bruch bei Regelentwick-lung |
|---|---|---|---|---|
| - | 7,00 | 6,31 | 1 - 4 | 1 - 4 |
| Phthalsäure/ Kaliumphthalat | 5,12 | 5,12 | 1 - 4 | 1 - 4 |
| $K_2HPO_4/KH_2PO_4$ | 6,34 | 6,34 | 1 - 4 | 1 -4 |
| $Cl^--H_3^+NC(CH_2OH)_3/$ $H_2N-\ C(CH_2OH)_3$ | 7,50 | 7,5 | 1 - 4 | 1 - 4 |

**Beispiel 5**

Es wird eine Beschichtungslösung hergestellt wie in Beispiel 1, jedoch ohne Zusatz von 2,4-Diethoxy-6-diethylamino-s-triazin als Base. Die Lösung wird auf eine entsprechend Beispiel 1 behandelte Aluminiumfolie zu einer Dicke von 2 µm nach Trocknung aufgebracht.

Belichtung, Umkehrverarbeitung und Entwicklung werden wie in Bsp. 1 durchgeführt. Die Konvertierung wird in VE-Wasser und die Entwicklung mit einer 5 %igen Lösung von Triethylentetramin durchgeführt mit einer Konversionszeit von 1 Minute und einer Entwicklungszeit von 30 Sekunden.

Tabelle 8

| Konver-sionstem-peratur [°C] \ Wiedergabe bei Regelentwicklung | Konvertierung in VE-Wasser | Konvertierung in basischer Lösung |
|---|---|---|
| 75 | - | - 3 |
| 80 | - 3 | 1 - 4 |
| 95 | 1 - 4 | 1 - 4 |

Das Beispiel zeigt, daß die Verbreiterung des Bildumkehrspielraums auch durch Zugabe einer basischen Substanz in die Konvertierungslösung möglich ist.

11

### Beispiel 6

Es werden Beschichtungslösungen hergestellt aus:

5 Gt eines Hochpolymeren des 2-Hydroxyphenylmethacrylates mit einem MW von 20.000,

1,4 Gt eines oligomeren Acetals, welches durch Polykondensation von Triethylenglykol und 2-Ethylbutyraldehyd erhalten wurde, Hydroxylzahl 140,

0,2 Gt 2-(4-Styrylphenyl)-4,6-bistrichlormethyl-s-triazin,

0,03 Gt Kristallviolett (C.I. 42555),

100 Gt des Lösungsmittelgemisches aus Beispiel 1.

Diese Lösungen werden auf Aluminiumplatten, die wie in Beispiel 1 vorbehandelt wurden, aufgeschleudert. Nach 2-minütiger Trocknung bei 100 °C resultiert eine Schichtdicke von 2,5 µm. Auf diese Kopierschicht wird dann eine nicht lichtempfindliche Deckschicht aus Polyvinylalkoholen (K-Wert 4, Restacetylgruppengehalt 12 %) entsprechend DE-A 37 15 790 aus Wasser in einer Stärke von 0,2 µm aufgebracht.

Mit diesem Material wird eine Umkehrverarbeitung durchgeführt:

```
Belichtung durch
Halbtonstufenkeil:              20 Sekunden

Konvertierung:                  1 Minute Heißluft bei 130°C
                                bzw.
                                1 Minute VE-Wasser-Bad bei 90°C

Belichtung ohne Vorlage
und ohne vorhergehende
Abkühlung:                      20 Sekunden
```

30 Sekunden Entwicklung in folgendem Entwickler:

5,3 Gt Natriumsilikat x 9 $H_2O$

3,4 Gt Trinatriumphosphat x 12 $H_2O$

0,3 Gt Natriumhydrogenphosphat (wasserfrei)

91,0 Gt Wasser.

In beiden Fällen resultiert eine Stufenwiedergabe 1 - 3.

Das Beispiel zeigt, daß das erfindungsgemäße Verfahren auch zur Umkehrverarbeitung von Materialien auf Basis von säurespaltbaren C-O-C-Bindungen anwendbar ist.

### Beispiel 7

Es werden Beschichtungslösungen hergestellt aus:

5 Gt des polymeren Bindemittels aus Beispiel 6,

0,5 Gt eines Veresterungsproduktes aus 3 Mol 1,2-Naphthochinon-2-diazid-4-sulfonylchlorid und 1 Mol 2,3,4-Trihydroxybenzophenon,

1,2 Gt des oligomeren Acetals aus Beispiel 6,

0,15 Gt 2-(4-Styrylphenyl)-4,6-bistrichlormethyl-s-triazin,

0,03 Gt Farbstoff wie in Beispiel 6,

100 Gt des Lösungsmittelgemisches aus Beispiel 1.

Diese Lösungen werden auf Aluminiumplatten aufgebracht, die wie in Beispiel 1 beschrieben vorbehandelt wurden, so daß nach 2 Minuten Trocknen bei 100 °C eine Schichtdicke von 2.000 nm vorliegt. Auf diese Kopierschicht wird eine Deckschicht aus Polyvinylalkohol, wie in Beispiel 6, aufgebracht.

Belichtung, Umkehrverarbeitung und Entwicklung werden exakt wie in Beispiel 6 durchgeführt.

Sowohl bei Heißluftkonvertierung als auch bei Konvertierung mit heißem Wasser resultiert eine Stufenwiedergabe von 1 - 3.

Das Beispiel zeigt, daß das erfindungsgemäße Verfahren zur Umkehrverarbeitung auch für Hybridmaterialien geeignet ist, die in ihrer lichtempfindlichen Schicht 1,2-Chinondiazide und Kombinationen von Verbindungen mit säurespaltbaren C-O-C-Gruppen und bei Bestrahlung eine starke Säure bildenden Verbindungen enthalten.

EP 0 432 609 B1

**Beispiel 8**

Die Umkehrverarbeitung entsprechend Beispiel 1 wurde wiederholt, wobei anstelle von VE-Wasser verschiedene Glycerin-Wasser-Mischungen eingesetzt wurden. Die Konvertierung erfolgte im Tauchbad, Zeit: 15 Sekunden, Temperatur und Ergebnisse mit dem Entwickler aus Beispiel 1 siehe folgende Tabelle 9:

## Tabelle 9

| Mischungsverhältnis Glycerin:Wasser 177 °C | | Tempe-ratur [°C] | Aufent-wicklung (15 Sek) | Wiedergabe bei Entwicklungs-zeit von 30 Sekunden |
|---|---|---|---|---|
| 10 | 0 | 75 | tont | tont |
| 9 | 1 | 75 | tonfrei | 1 - 5 |
| 8 | 2 | 75 | tonfrei | 1 - 5 |
| 7 | 3 | 75 | tonfrei | 1 - 5 |

## Patentansprüche

1. Verfahren zur Herstellung negativer Kopien, bei dem ein licht- bzw. strahlungsempfindliches Aufzeichnungsmaterial aus einem Schichtträger und einer darauf aufgebrachten normalerweise positiv arbeitenden licht- bzw. strahlungsempfindlichen Schicht, die als wesentliche Bestandteile ein 1,2-Chinondiazid und/oder ein Gemisch aus einer unter Einwirkung von aktinischer Strahlung starke Säure bildenden Verbindung und einer Verbindung mit mindestens einer durch Säure spaltbaren C-O-C- Gruppierung enthält, bildmäßig bestrahlt, thermisch behandelt, nach Abkühlen vollflächig bestrahlt und dann mit einem alkalischen Entwickler entwickelt wird, dadurch gekennzeichnet, daß man die thermische Behandlung mit Wasser oder mit einer wäßrigen Lösung bei Temperaturen im Bereich von etwa 50 bis 100 °C innerhalb von etwa 1 Sekunde und 5 Minuten, die vollflächige Bestrahlung an dem noch warmen Aufzeichnungsmaterial und die anschließende Entwicklung innerhalb von etwa 10 Sekunden und 2 Minuten durchführt.

2. Verfahren nach Anspruch 1, dadurch gekennzeichnet, daß man die thermische Behandlung in einem Temperaturbereich von etwa 60 - 90 °C vornimmt.

3. Verfahren nach Anspruch 1, dadurch gekennzeichnet, daß man die thermische Behandlung innerhalb von etwa 5 Sekunden und 1 Minute vornimmt.

4. Verfahren nach Anspruch 1, dadurch gekennzeichnet, daß man die thermische Behandlung mit einer wäßrigen Lösung vornimmt, die mindestens eine oberflächenaktive Substanz enthält.

5. Verfahren nach Ansprüchen 1 und 4, dadurch gekennzeichnet, daß die wäßrige Lösung einen pH-Wert von 5 - 8 aufweist.

6. Verfahren nach Ansprüchen 1, 4 und 5 , dadurch gekennzeichnet, daß die wäßrige Lösung im pH-Bereich von 5 - 8 gepuffert ist.

7. Verfahren nach Anspruch 1, dadurch gekennzeichnet, daß die wäßrige Lösung Komplexbildner enthält.

13

8. Verfahren nach Anspruch 1, dadurch gekennzeichnet, daß die wäßrige Lösung einen Zusatz zur Erhöhung der Wärmeleitfähigkeit enthält.

9. Verfahren nach Anspruch 1, dadurch gekennzeichnet, daß die wäßrige Lösung Antischaummittel enthält.

10. Verfahren nach Anspruch 1, dadurch gekennzeichnet, daß die wäßrige Lösung einen Zusatz zur Erhöhung der Viskosität enthält.

11. Verfahren nach Anspruch 1, dadurch gekennzeichnet, daß man die vollflächige Bestrahlung im Temperaturbereich von etwa 50 - 90 °C durchführt.

12. Verfahren nach Anspruch 1, dadurch gekennzeichnet, daß man die Entwicklung innerhalb von etwa 15 Sekunden und 1 Minute vornimmt.

## Claims

1. Process for producing negative copies, in which a light-sensitive or radiation-sensitive recording material comprising a layer support and a normally positive-working light-sensitive or radiation-sensitive layer applied thereto which contains, as the essential constituents, a 1,2-quinone diazide and/or a mixture of a compound forming a strong acid under the action of actinic radiation and a compound having a least one acid-cleavable C-O-C group, is irradiated imagewise, thermally treated, after cooling irradiated overall and then developed with an alkaline developer, wherein thermal treatment is carried out with water or with an aqueous solution, at temperatures in the range from about 50 to 100 °C, within a period of time varying between about 1 second and 5 minutes, overall irradiation is performed on the still hot recording material and development is thereafter carried out within a period of time varying between about 10 seconds and 2 minutes.

2. The process as claimed in claim 1, wherein thermal treatment is carried out in the temperature range from about 60 to 90 °C.

3. The process as claimed in claim 1, wherein thermal treatment is carried out within a period of time varying between about 5 seconds and 1 minute.

4. The process as claimed in claim 1, wherein thermal treatment is carried out using an aqueous solution which contains at least one surface-active substance.

5. The process as claimed in claims 1 and 4, wherein the aqueous solution has a ph varying from 5 to 8.

6. The process as claimed in claims 1,4 and 5, wherein the aqueous solution is buffered in the pH range from 5 to 8.

7. The process as claimed in claim 1, wherein the aqueous solution contains complexing agents.

8. The process as claimed in claim 1, wherein the aqueous solution contains an addition to increase its heat conductivity.

9. The process as claimed in claim 1, wherein the aqueous solution contains defoamers.

10. The process as claimed in claim 1, wherein the aqueous solution contains an addition to increase its viscosity.

11. The process as claimed in claim 1, wherein overall irradiation is carried out in the temperature range from about 50 to 90 °C.

12. The process as claimed in claim 1, wherein development is carried out within a period of time varying between about 15 seconds and 1 minute.

## Revendications

1. Procédé pour la préparation de négatifs par lequel un matériau d'enregistrement sensible à la lumière ou aux radiations, constitué d'une couche support et d'une couche sensible à la lumière ou aux radiations travaillant normalement en positif disposée sur ladite couche support, qui contient comme constituants essentiels un 1,2-quinonediazide et/ou un mélange d'un composé conduisant à un acide fort sous l'action d'un rayonnement actinique et d'un composé présentant au moins un groupe C-O-C- dissociable par action d'un acide, est irradié selon l'image, est traité thermiquement, puis après refroidissement est irradié sur la totalité de la surface et ensuite est développé à l'aide d'un révélateur alcalin, caractérisé en ce que, on réalise le traitement thermique par action d'eau ou d'une solution aqueuse dans une plage de températures située entre 50 jusqu'à 100° C pendant environ 1 seconde à 5 minutes, on réalise le traitement sur la surface totale à partir du matériau d'enregistrement encore chaud et en ce qu'on réalise le développement final pendant environ 10 secondes à 2 minutes.

2. Procédé selon la revendication 1 caractérisé en ce qu'on effectue le traitement thermique dans une plage de températures comprise entre environ 60-90° C.

3. Procédé selon la revendication 1, caractérisé en ce qu'on effectue le traitement thermique pendant environ 5 secondes à 1 minute.

4. Procédé selon la revendication 1, caractérisé en ce qu'on effectue le traitement thermique par action d'une solution aqueuse comprenant au moins une substance tensio-active.

5. Procédé selon la revendication 1 ou 4, caractérisé en ce que la solution aqueuse présente un pH compris entre 5 et 8.

6. Procédé selon l'une des revendications 1, 4 ou 5, caractérisé en ce que la solution aqueuse est tamponnée dans une plage de pH comprise entre 5 et 8.

7. Procédé selon la revendication 1, caractérisé en ce que la solution aqueuse comprend un agent complexant.

8. Procédé selon la revendication 1, caractérisé en ce que la solution aqueuse comprend un additif pour augmenter la conductivité à chaud.

9. Procédé selon la revendication 1, caractérisé en ce que la solution aqueuse comprend un agent anti-mousse.

10. Procédé selon la revendication 1, caractérisé en ce que la solution aqueuse comprend un additif pour augmenter la viscosité.

11. Procédé selon la revendication 1, caractérisé en ce que l'on réalise le rayonnement de la totalité de la surface dans une plage de températures comprise entre environ 50 et 90° C.

12. Procédé selon la revendication 1, caractérisé en ce que l'on effectue le développement pendant environ 15 secondes à 1 minute.